# EUROPEAN PATENT APPLICATION

(11) **EP 1 632 783 A1**
(43) Date of publication of application: **08.03.2006**
(21) Application number: 05291813.3
(22) Date of filing: 31.08.2005
(51) Int. Cl.: G01R 33/035, G01R 33/07, G01R 33/09, G01R 15/20, G09G 3/00, G01R 31/315, G01R 31/02

(54) **Magnetic sensor for detecting location of short circuit between lead wires of high-density micro-patterns**

(30) Priority: 03.09.2004 KR 70475
(71) Applicant: LG ELECTRONICS INC., Seoul 150-721 (KR)
(72) Inventor: Jeong, Dae-Hwa, 447-800 Gyeonggi-do (KR); Lee, Seung-Min, Bojeon Guseong-eup Yongin-si Gyeonggi-do (KR)
(74) Representative: Loisel, Bertrand

(57) **Abstract**

The present invention relates to a sensor, which detects the short circuit between high-density integrated lead wires formed on various boards, such as used in a flat panel display, in a non-contact manner, wherein an electric field is blocked by a conductor.

According to the present invention, the present invention is advantageous in that it greatly improves detection performance and increases the capability to detect short circuit defects at the time of detecting a magnetic field when an electromotive force, caused by the induction of an electric field, is induced at a magnetic sensor, as in the case of a flat panel display, so that defects in metal patterns can be rapidly detected and corrected at an early stage of a manufacturing process, in cooperation with other defect testers, such as an external shape tester, thus remarkably reducing reworking costs.

## Description

### BACKGROUND OF THE INVENTION

### Field of the Invention

The present invention relates, in general, to a magnetic sensor for detecting the location of the short circuit of lead wires having high-density micro-patterns and, more particularly, to the manufacture of a sensor, which detects short circuits between high-density integrated lead wires formed on various boards, including a flat panel display or printed circuit board, using a magnetic sensor in a non-contact manner.

### Description of the Related Art

Generally, non-destructive testing using a magnetic sensor is a method that has been developed to examine whether micro-defects exist in metal or on the surface of the metal due to external impacts or degradation, and that can be usefully utilized for periodical safety tests for mechanical devices or structures. In such magnetic field non-destructive testing, when an Alternating Current (AC) magnetic field is formed around a metal object, local variation in the magnetic field caused by an eddy current induced at the boundary of the metal is measured. As a sensor for sensing variation in a magnetic field, a magnetic resistor, coil, fluxgate, etc. is generally used. In particular, if a Superconducting Quantum Interference Device (SQUID) that is a superconducting device is used, very fine metal defects or defects occurring in a location far away from a surface can be detected (Refer to Annu. Rev. Mater. Sci. 1999. 29:117-48,. Physica C 335 2000 179-183).

A conventional magnetic field non-destructive testing method using an eddy current determines whether defects exist on the basis of the shape obtained by a two-dimensional scan. In this method, an AC magnetic field having a constant amplitude is applied. At this time, the surface or boundary of metal is partially shielded due to induced eddy current, so that the amplitude of the magnetic field is reduced. Therefore, this variation is detected and the shape of an eddy current based on the actual shape of the metal is obtained. The shape of a local eddy current, occurring when a defect exists in an object, is obtained.

In order to implement this technology, in the prior art, a method of using a sensor for detecting a magnetic field, a coil for generating a uniform AC magnetic field or local magnetic field, a signal generator, a lock-in amplifier functioning to measure an effective value or peak-peak value on the basis of a signal output from the sensor, or a peak detector using other schemes, and analyzing the output of the amplifier or peak detector, has been used.

Meanwhile, a method of applying a current to a conducting sample, measuring a magnetic field formed by the flow of the current and detecting defects in an object can be implemented. However, this method is not generally used because the ratio of a background signal to a target signal is not high, and current is caused to flow through a sample, so that the sample is influenced by the current to a certain extent.

In a flat panel display, a method of causing test current to flow only when a short circuit between lead wires occurs, while maintaining the open circuit between the lead wires when no defect occurs, and detecting a magnetic field formed by the test current is used. This method can detect the location of a short circuit defect because of a high ratio of a signal to a background signal (refer to U.S. Pat. No. 5,073,754 filed by Photon Dynamics, Inc.: PDI).

The recent development of flat panel displays has been rapid. A flat panel display is composed of grids formed in a matrix shape, and requires a grid patterning process. Defects occurring during the grid patterning process greatly influence yield (for example, refer to Fujitsu Patent belonging to IPC code: H01J-011/00 H01J-011/02 for structure of Plasma Display Panel [PDP] , and refer to In Plane Switching [IPS] mode for the structure of Liquid Crystal Display [LCD]) .

Therefore, defect inspection in a manufacturing process plays an important role in decreasing the manufacturing costs in these fields. The defect inspection in a manufacturing process includes various defect inspections. When high-density micro-lead wires are integrated, as in the case of flat panel displays, a method of detecting a magnetic field is generally used to detect short circuits between lead wires. However, this method is problematic in that, since the intensity of an electric field is much greater than that of a magnetic field, it is difficult to easily detect the magnetic field.

### SUMMARY OF THE INVENTION

Accordingly, the present invention has been made keeping in mind the above problems occurring in the prior art, and an object of the present invention is to provide a sensor having excellent ability to detect a magnetic field signal generated by a short circuit between lead wires in a sample having a specific structure.

In order to accomplish the above object, the present invention provides a sensor for detecting short circuits between high-density integrated lead wires formed on various boards, such as used in a flat panel display, in a non-contact manner, the sensor being shielded from an electric field by a conductor.

Preferably, the sensor may be implemented so that the surfaces thereof, except for any one surface, are shielded by a conductor.

Preferably, the sensor may be formed on the top of the conductor.

Preferably, the sensor may be formed in the shape of at least one coil, using the conductor as a core.

Preferably, the conductor may be grounded.

### BRIEF DESCRIPTION OF THE DRAWINGS

FIG. 1 is a sectional view of a magnetic sensor according to an embodiment of the present invention;
FIG. 2 is a perspective view of a magnetic sensor according to another embodiment of the present invention;
FIG. 3 is a perspective view of a magnetic sensor according to a further embodiment of the present invention;
FIG. 4 is a graph showing the signal output of a magnetic sensor before and after shielding, according to an embodiment of the present invention; and
FIG. 5 is a graph showing differences in signal variation when the signal output of a magnetic sensor before and after shielding is standardized at a specific location according to an embodiment of the present invention.

### DESCRIPTION OF THE PREFERRED EMBODIMENTS

Hereinafter, embodiments of the present invention will be described in detail with reference to the attached drawings. Reference now should be made to the drawings, in which the same reference numerals are used throughout the different drawings to designate the same or similar components. In the following description of the present invention, detailed descriptions may be omitted if it is determined that the detailed descriptions of related well-known functions and construction may make the gist of the present invention unclear.

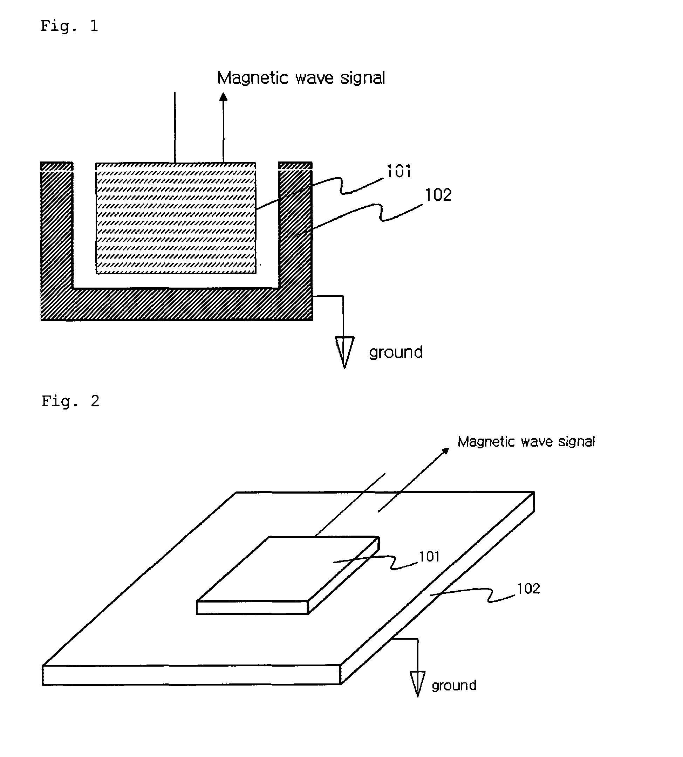

FIGS. 1 to 3 are sectional views of a magnetic sensor according to embodiments of the present invention.

In the embodiments, a magnetic sensor 101 may be formed in the shape of a regular hexahedron, a rectangular parallelepiped or a coil.

The embodiments schematically show methods of forming the magnetic sensor 101 on a conductor 102.

FIG. 1 shows that the outer surfaces of a regular hexahedral magnetic sensor 101, except for the top surface, are shielded by the conductor 102. The conductor 102 is externally grounded. Since the magnetic sensor 101 is open on its top surface, an electric field signal is generated only through the top surface.

FIG. 2 shows that a magnetic sensor 101 is formed on the top of a planar conductor 102. The planar conductor 102 is also externally grounded, and an electric field signal is generated only through the front surface of the conductor 102.

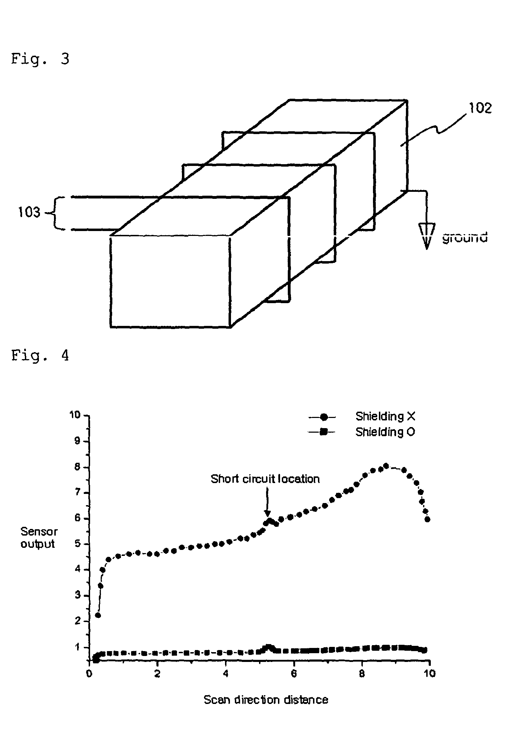

FIG. 3 shows that a coil sensor 103 is formed by utilizing a conductor 102 as a core. The coil sensor 103 is wound around the conductor 102 at least once, and the conductor 102 is also externally grounded.

Generally, the magnetic sensor 101 uses only a material or structure (coil) reacting to a magnetic field. In this case, when a typical magnetic field is detected, there is no problem. Even when a device is packaged, a conductive material is not generally used except for the case in which hard metal is used to protect a sensor at the time of detecting a magneto-static field. This is due to the fact that, if metal exists nearby, high frequency response characteristics are deteriorated due to the shielding current caused by the metal, so that a problem may occur in the detection of an AC magnetic field. Actually, most magnetic sensors 101 have better sensitivity at high frequencies rather than low frequencies, so that a method of using AC rather than a method of using DC is preferred. Therefore, packaging is conducted without using metal.

However, in the case of the inspection of short circuits between wires in a flat panel display, an AC voltage is induced over all of the surfaces of an object to be detected when an AC test voltage is applied to the panel, so that AC current is coupled to the AC voltage through the magnetic sensor 101, and flows into a sensor circuit.

In particular, in the case of micro-defect inspection in which a magnetic field signal to be observed is very low and which requires high-speed response characteristics, an AC magnetic field signal is very low compared to an induced AC electric field signal. Furthermore, when the AC electric field signal is greater than the AC magnetic field signal, a signal generated by variation in the coupling of the electric field becomes greater than the magnetic field signal if the distance between the sensor and the sample is not uniform due to mechanical vibration, thus deteriorating the Signal to Noise (S/N) ratio of the magnetic sensor to such an extent that it is impossible to detect signals.

Therefore, an electric field is suitably blocked, and bypass shielding need only be performed to prevent an electrically induced signal from flowing into the magnetic sensor itself. FIGS. 1 to 3 show several methods of performing the above operation.

In each case, if a conductor is thick, a magnetic field is also blocked or offset by shielding current, so it is preferable to use a conductor several tens of times thinner than a skip depth, depending on AC frequency. In another method, material having low conductivity and non-magnetic characteristics is used, so that the thickness of the material may effectively be less than the skin depth.

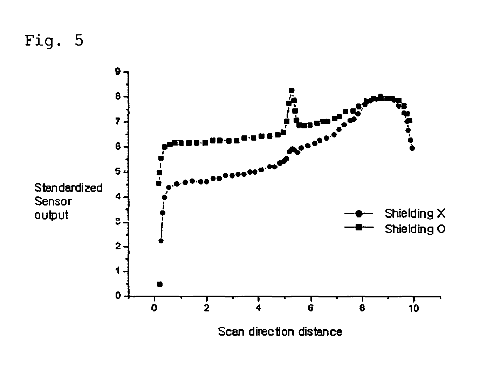

FIGS. 4 and 5 illustrate the output of a magnetic sensor when voltage is applied to a flat panel display, on which an artificial short circuit is formed, and the magnetic sensor scans the flat panel display, before and after shielding. An AC signal is amplified by a lock-in amplifier. Although the signal from the magnetic sensor after shielding is shown as if it decreases about 10 times, the magnitude of the absolute value of a magnetic field signal is not changed. When shielding is not conducted, a signal obtained according to a scan direction distance is formed due to the deformation of an electric field caused by the shape of a lead wire or surrounding object, and may occasionally cause a background signal that interferes with the discrimination of a magnetic field signal caused by a short circuit, depending on the implementation of a system. Although the level of an entire signal is decreased after shielding, a magnetic field to be detected remains unchanged, thus consequently improving the signal to offset ratio.

FIG. 5 shows that the output signal of the sensor is converted to a standardized signal and displayed to observe relative variation.

As described above, the present invention provides a magnetic sensor, which greatly improves detection performance and increases the capability to detect short circuit defects at the time of detecting a magnetic field when an electromotive force, caused by the induction of an electric field, is induced at a magnetic sensor, as in the case of a flat panel display, so that defects in metal patterns can be rapidly detected and corrected at an early stage of a manufacturing process, in cooperation with other defect testers, such as an external shape tester, thus remarkably reducing reworking costs.

Although the preferred embodiments of the present invention have been disclosed for illustrative purposes, those skilled in the art will appreciate that various modifications, additions and substitutions are possible, without departing from the scope and spirit of the invention as disclosed in the accompanying claims.

## Claims

1. A sensor for detecting short circuits between high-density integrated lead wires formed on various boards, such as used in a flat panel display, in a non-contact manner, wherein:
the sensor is shielded from an electric field by a conductor.

2. The sensor according to claim 1, wherein the sensor is implemented so that surfaces thereof, except for any one surface, are shielded by a conductor.

3. The sensor according to claim 1, wherein the sensor is formed on top of the conductor.

4. The sensor according to claim 3, wherein the conductor has a surface facing the sensor, the surface of the conductor having an area greater than that of a surface of the sensor facing the conductor.

5. The sensor according to claim 1, wherein the sensor is formed in a shape of at least one coil, using the conductor as a core.

6. The sensor according to claim 1, wherein the conductor is grounded.
